# FASCICULE DE BREVET EUROPEEN

(11) **EP 1 537 762 B1**
(45) Date de publication et mention de la délivrance du brevet: **05.04.2006**
(21) Numéro de dépôt: 03769575.6
(22) Date de dépôt: 05.09.2003
(51) Int. Cl.: H05B 3/84

(54) **DISPOSITIF DE RACCORDEMENT POUR UN ELEMENT PLAT EN PLUSIEURS COUCHES EQUIPE D'ELEMENTS FONCTIONNELS ELECTRIQUES ET ELEMENT PLAT**
VERBINDUNGSEINRICHTUNG FÜR EIN FLÄCHIGES ELEMENT MIT MEHREREN SCHICHTEN AUSGESTATTET MIT ELEKTRISCHEN FUNKTIONSELEMENTEN UND FLÄCHIGES ELEMENT
CONNECTING DEVICE FOR A MULTILAYER FLAT ELEMENT EQUIPPED WITH ELECTRICAL FUNCTIONAL ELEMENTS AND FLAT ELEMENT

(30) Priorité: 10.09.2002 DE 10241728; 28.05.2003 DE 20308376 U
(43) Date de publication de la demande: 08.06.2005
(73) Titulaire: SAINT-GOBAIN GLASS FRANCE, 92400 Courbevoie (FR)
(72) Inventeur: MANN, Detlef, 91710 Gunzenhausen (DE)
(74) Mandataire: Aupetit, Muriel J. C.
(86) Numéro de dépôt international: PCT/FR2003/002651
(87) Numéro de publication internationale: WO 2004/025995

(56) Documents cités:
- DE-A- 4 325 024
- FR-A- 2 646 968
- FR-A- 2 652 980
- GB-A- 1 159 390
- US-A- 2 982 934

## Description

L'invention concerne un dispositif de raccordement pour un élément plat en plusieurs couches qui comprend une première vitre rigide dotée d'un ou de plusieurs éléments fonctionnels électriques ainsi qu'une deuxième vitre rigide reliée à plat au côté de la première vitre rigide dotée des éléments fonctionnels, cette dernière présentant au moins une découpe pour la réalisation d'un raccordement électrique aux éléments fonctionnels.

L'invention vise aussi un élément plat équipé d'un tel dispositif de raccordement.

On sait de manière générale que des systèmes à couches minces électriquement conducteurs peuvent être utilisés comme résistances chauffantes par application d'une tension électrique. Il existe de nombreuses applications de cette technique tant dans le secteur automobile que dans le secteur de la construction.

En général, ces systèmes de couches déposés sur des substrats plats, par exemple des vitrages, comprennent au moins une couche métallique, par exemple en argent, ainsi que (pour les systèmes de couches transparents) des couches diélectriques des deux côtés de la couche d'argent, et éventuellement aussi des couches de blocage en différents matériaux, et parmi celles-ci également des couches de recouvrement pour le renforcement de la capacité de résistance mécanique de la structure de couche. Dans de nombreux cas, on utilise également les propriétés de réflexion du rayonnement infrarouge de systèmes de couches comme isolation thermique.

L'établissement d'une densité homogène de courant dans ces systèmes de couches utilisés comme couches chauffantes est la plupart du temps problématique. Il s'agit surtout d'éviter que des endroits soient localement surchauffés par de hautes densités de courant, ce que l'on appelle "hot spots" - points chauds. Dans ce but et dans de nombreuses applications, on dote la couche chauffante d'électrodes planes en forme de ruban. Elles sont par exemple constituées de minces rubans métalliques déposés ou de couleurs bonnes conductrices de l'électricité, qui sont imprimées et éventuellement cuites, et elles permettent d'introduire et d'évacuer le courant sur une base aussi large que possible. Cependant, dans la plupart des cas, ces raccordements ne satisfont pas des exigences optiques-esthétiques et doivent par conséquent être masqués. Comme ils sont la plupart du temps situés sur le bord du substrat, dans de nombreuses applications, par exemple pour les vitres de véhicules, on peut les réaliser avec une mise en oeuvre réduite.

On sait en outre dans de telles couches chauffantes, comment agir sur les écoulements et les répartitions du courant grâce à de fines lignes qui divisent la couche chauffante en tronçons ou parcours de courant individuels, raccordés électriquement en parallèle les uns par rapport aux autres, et dont les résistances ohmiques sont si possible toutes identiques.

Dans la demande de brevet allemand 102 08 552.8, on décrit un élément en plaque doté d'un revêtement électriquement conducteur ("couche chauffante") qui convient pour être raccordé directement aux tensions de réseau habituel dans le domaine domestique. Il est essentiellement constitué d'une structure composite en plusieurs couches qui comprend une première vitre rigide avec la couche chauffante déposée sur elle, ainsi qu'une couche adhérente et qu'une deuxième vitre rigide. Dans la zone de raccordement électrique de la couche chauffante, la deuxième vitre rigide est dotée d'un alésage. Dans la zone de cet alésage, deux zones de polarité différente de la couche chauffante sont situées en étroite proximité. Sur chacune de ces zones est prévue une électrode appliquée sur la couche chauffante et à laquelle une amenée de courant est reliée par soudage tendre. L'écoulement de courant entre les deux bornes de raccordement qui appartiennent à la même couche chauffante est guidé de la manière déjà mentionnée par division de la couche chauffante au moyen de fines lignes.

Dans DE-U1-201 07 908 est décrit un dispositif de raccordement dans lequel un vitrage revêtu de manière à être électriquement conducteur est doté d'éléments de maintien qui présentent la forme de ferrures de serrage qui servent en même temps de supports à des contacts électriques. Des languettes élastiques intégrées dans les ferrures de serrage sont appliquées de manière électriquement conductrice sur le revêtement du vitrage et repoussées contre ce dernier.

Dans un autre contexte, DE-A1-199 58 879 décrit un vitrage isolant doté d'une vitre en verre composite dont la couche adhérente intègre des éléments fonctionnels (cellules solaires). Ces conducteurs de raccordement électrique sont chacun passés dans une découpe ménagée dans l'une des vitres du composite ainsi que dans la vitre rigide opposée du verre isolant, la zone de cette traversée dans l'espace intermédiaire du verre isolant entre ces vitrages étant entourée par un écarteur de forme annulaire. Les conducteurs peuvent également être passés par un tourillon creux d'un support ponctuel qui est utilisé pour fixer le vitrage isolant sur une structure sous-jacente.

Dans le domaine des ferrures et des fixations de vitrages composites, on connaît (DE-A1-39 08 983, DE-C2-43 25 024, DE-U1-87 01 693) la technique qui consiste à prévoir dans la vitre rigide des découpes dans lesquelles les éléments de fixation peuvent être insérés et fixés. Ces éléments de fixation peuvent présenter des saillies en collet radial qui s'étendent dans la couche adhésive du composite et qui, lorsque l'ensemble est terminé, s'engagent par l'arrière dans le vitrage. Leurs découpes peuvent éventuellement présenter une contre-dépouille. Dans ce dernier cas, on a également décrit des chevilles à contre-dépouille pour des fixations de verre composite (DE-A1-38 11 249). La surface de l'autre côté de ces vitrages composites reste chaque fois entièrement intacte. Les sources mentionnées en dernier lieu ne se préoccupent pas de dispositifs de raccordement électrique.

Enfin, on connaît du document DE-U1-78 01 989 un miroir feuilleté muni d'un élément de chauffage sous la forme d'un réseau de conducteurs sérigraphiés formant des éléments linéaires de chauffage qui est alimenté électriquement par un dispositif de connexion inséré dans un trou de l'une des vitres et coopérant mécaniquement avec ce trou pour son maintien, ce dispositif ayant deux contacts connectés aux deux pôles du réseau de conducteurs sérigraphiés.

L'objet de l'invention est d'améliorer encore un dispositif de raccordement du type indiqué au début et de créer un élément plat chauffant qui en est équipé.

Selon l'invention, cet objet est atteint par la revendication 1. Cet élément chauffant a l'avantage d'être transparent. De plus, il s'avère que de manière inattendue avec un tel dispositif de raccordement, la disposition de deux zones de mise en contact électrique au niveau du revêtement électriquement conducteur du type couche chauffante, qui présente pourtant une résistance ohmique considérablement plus élevée qu'avec des revêtements sérigraphiés formant des éléments linéaires de chauffage, n'engendre pas d'endroits de surchauffe électrique. Par ailleurs, on équipe un élément plat avec des éléments fonctionnels électriques incorporés entre deux plaques rigides et au moins un dispositif de raccordement selon l'invention. Les caractéristiques des revendications dépendantes donnent des développements avantageux de ces objets.

Selon l'invention, on place dans la découpe de l'une des vitres rigides une pièce de garniture qui sert de contre-appui pour la fixation d'au moins un élément de raccordement relié électriquement à l'élément fonctionnel. Cette pièce de garniture possède ou forme une saillie (radiale) qui est ancrée en correspondance géométrique dans la découpe.

Comme éléments fonctionnels électriques, on envisage surtout des éléments chauffants, en particulier des couches chauffantes, mais également des éléments solaires, des capteurs, qui sont chaque fois incorporés dans une structure en plusieurs couches et doivent être mis en contact électrique avec l'extérieur. Pour la structure décrite ici du dispositif de raccordement ou de la pièce de garniture, la fonction des éléments qu'il faut finalement raccorder est d'une importance secondaire.

Les éléments fonctionnels peuvent en l'occurrence être disposés aussi bien sur la vitre rigide avec la découpe que sur la vitre rigide se trouvant en regard de celle-ci. On peut en outre envisager des réalisations dans lesquelles les deux vitres sont pourvues d'éléments fonctionnels électriques, par exemple des électrodes pour des éléments d'éclairage électroluminescents ou des cellules solaires, et sont équipées d'un ou de plusieurs éléments de raccordement selon l'invention.

Le bord de la découpe peut accrocher par l'arrière ladite saillie de la pièce de garniture dans le plan situé entre les deux vitres rigides (plan de la couche adhésive). On fixera alors cette pièce de garniture dans la découpe avant la fabrication de l'ensemble de vitrage de telle sorte que la saillie puisse être incorporée dans la couche adhésive. L'épaisseur de la saillie sera alors inférieure à l'épaisseur de la couche adhésive.

La saillie peut également s'engager derrière une couche arrière ou un chanfrein de la découpe, située à l'intérieur du composite. Cela peut être réalisé de manière connue en soi par une garniture en plusieurs pièces dont les pièces individuelles sont placées ensemble dans la découpe proprement dite. Comme pièce de garniture, on peut cependant aussi utiliser une cheville à contre-découpe appropriée qui ne forme ladite saillie que lorsqu'elle a été passée dans la découpe et y a été serrée. Les deux variantes peuvent être installées avantageusement après la fabrication de l'ensemble de vitrage.

De manière particulièrement préférée, la pièce de garniture peut être utilisée comme base pour un point de collecte de l'ensemble des fonctions d'interface électrique de l'élément plat.

Elle forme ensuite la base des contacts de raccordement électrique proprement dits qui sont de préférence configurés comme contacts à ressort. Pour l'application principalement prévue dans un élément chauffant plat dont les tensions de travail sont relativement élevées, ils ne doivent transférer qu'un faible courant (alternatif); également, les éléments chauffants utilisés dans des bâtiments ne sont en règle générale exposés à aucune vibration. Ainsi, il ne faut pas s'attendre à des problèmes de corrosion qui dans d'autres domaines d'utilisation (construction de véhicules) peuvent avoir des effets de détérioration du contact par de hautes résistances de transfert. De plus, en cas de besoin, la zone du contact peut être scellée hermétiquement de telle sorte que l'humidité et les encrassements ne puissent pénétrer.

En cas de besoin, les contacts électriques avec les éléments fonctionnels ou leurs électrodes peuvent cependant aussi être réalisés par soudage tendre ou n'être protégés qu'en supplément. On connaît des techniques de soudage tendre qui permettent de faire fondre de manière sûre ces emplacements de soudage sans contact direct avec la source de chaleur (soudage par induction ou soudage au laser), et qui peuvent être utilisées même à travers la vitre revêtue sans détruire le revêtement.

La pièce de garniture peut servir de base pour une fiche de raccordement par laquelle on peut relier électriquement un conducteur de raccordement des éléments fonctionnels. Mais il est évident que l'on peut également prévoir un conducteur de raccordement fixe que l'on fait sortir d'un boîtier de raccordement fixé sur la pièce de garniture et qui présente éventuellement une fiche à son extrémité.

Dans une autre variante préférée, au moins un organe de commutation pour la mise en marche et l'arrêt des éléments fonctionnels est prévue dans la zone de la pièce de garniture. Dans l'utilisation comme "élément chauffant plat", cet organe de commutation peut, dans une autre variante avantageuse, être commandé par au moins une sonde de température qui détecte la température effective de la couche chauffante dans la zone de raccordement. Comme dans cette zone de l'alimentation locale en puissance électrique, les plus hautes densités de courant pourraient apparaître, on y disposera au moins une sonde de température.

Ces sondes de température peuvent même être également réalisées comme limiteurs de courant (par exemple des conducteurs froids dont la résistance électrique/ohmique augmente lorsque la température augmente), ce qui permet de supprimer ledit organe de commutation si l'on prévoit une ligne caractéristique appropriée. Eventuellement, on peut encore prévoir une protection électrique qui protège électriquement l'élément fonctionnel concerné.

Dans encore une autre variante avantageuse, la pièce de garniture peut également former la base d'un dispositif d'évaluation ou de réception des signaux de commande par lesquels un élément fonctionnel/élément chauffant de surface peuvent être sollicités individuellement par une commande à distance et être branchés et débranchés. Dans le cas d'un chauffage, ces signaux de commande sont créés par exemple à l'aide de thermostats d'ambiance et de sondes de température. Ils peuvent être transmis par des conducteurs spéciaux ou par les conducteurs d'alimentation déjà prévus comme conducteurs bus. Dans ce dernier cas, des impulsions de commande codées sont superposées à la tension d'alimentation ou du réseau et peuvent être filtrées électroniquement dans le dispositif de raccordement de l'élément chauffant de surface concerné. De préférence, les signaux de commande sont cependant transmis sans fil par radio, infrarouge, etc., et dans la zone du dispositif de raccordement, on prévoira un récepteur et un décodeur appropriés en plus des organes de commutation ou de commande raccordés en aval.

De manière complémentaire, la pièce de garniture peut être utilisée comme base pour une limitation de température réglable manuellement qui permet avec une priorité par rapport à la sonde interne de température éventuellement prévue de définir une puissance électrique maximale consommée et donc la température effective maximale de l'élément chauffant plat, en dessous de la température maximale absolue prédéterminée en usine de l'élément chauffant plat concerné.

Dans un mode de réalisation particulièrement préféré, on miniaturisera autant que possible l'ensemble des composants nécessaires (par exemple sous la forme d'une micropuce ou d'un microprocesseur) et on les rassemblera dans un boîtier ou une boîte de raccordement qui peuvent être fixés avec une mise en oeuvre réduite sur ladite pièce de garniture. Pour la liaison, on peut prévoir des vis. On pourrait cependant aussi prévoir une liaison encliquetable (libérable) si l'étanchéité nécessaire de la zone du contact peut ainsi être obtenue. Eventuellement, on pourrait encore envisager une liaison collée entre la pièce de garniture et la boîte de raccordement.

En même temps que la fixation de ladite boîte de raccordement, on peut également relier les contacts électriques (à ressort) aux éléments fonctionnels. Cela présente l'avantage d'une part de ne pas dépasser une pression d'épreuve prédéfinie des contacts, et d'autre part qu'en cas de libération et d'enlèvement ultérieurs éventuels de la boîte de raccordement dans un but d'entretien ou de réparation, de désactiver également les éléments fonctionnels en les débranchant du courant ou électriquement..

L'ensemble des éléments actifs du dispositif de raccordement peuvent, éventuellement après adaptation appropriée du niveau de tension, être alimentés électriquement par une tension de fonctionnement éventuellement appliquée telle quelle aux éléments fonctionnels. On pourrait cependant aussi les alimenter de manière autonome à l'aide de batteries qui seront placées dans la boîte de raccordement.

Dans la zone du raccordement, on peut également prévoir avec une faible mise en oeuvre des indications de fonctionnement qui permettent de vérifier si les éléments fonctionnels sont branchés, activés ou prêts à fonctionner ("stand by" - en attente). Lorsqu'il s'agit d'un élément plat transparent, ces affichages peuvent être des signaux lumineux dont la lumière traverse l'élément plat. Il est évident qu'alors ils ne seront pas recouverts par des masques opaques ou similaires, ou que des fenêtres d'observation appropriées seront prévues dans un tel masque.

Dans toutes les différences du dispositif de raccordement ici décrit par rapport aux éléments de fixation ponctuelle habituellement utilisés pour des plaques (de verre), on peut également imaginer d'utiliser un point de raccordement qui présente les caractéristiques décrites ici également comme points de fixation pour l'élément plat lorsque l'élément de fixation peut être adapté aux conditions imposées sur le plan électrique et que son montage sur une structure sous-jacente est possible. Cette dernière peut par exemple présenter des dispositifs de suspension du ou des éléments plats qui correspondent à des contre-supports appropriés prévus sur la boîte de raccordement qui sera configurée de manière à présenter une stabilité appropriée. Sinon, l'élément plat sera fixé dans sa position de montage à l'aide d'autres moyens appropriés qui engagent par exemple son bord (par exemple des cadres, des pinces de retenue), ou également être intégré à chant dans une paroi ou une façade à fenêtre.

Le dispositif de raccordement selon l'invention peut être installé de manière avantageuse pratiquement partout à la surface de l'élément plat, que ce soit à proximité du bord ou dans la zone centrale. Il est évident qu'en cas de besoin, plusieurs de ces dispositifs de raccordement peuvent être prévus sur le même élément plat, par exemple si plusieurs champs de chauffage ou modules de cellules solaires aptes à fonctionner indépendamment doivent être raccordés.

Lors du placement du dispositif de raccordement d'un élément chauffant plat, l'exigence d'une densité de courant aussi homogène que possible dans la couche chauffante à alimenter reste un paramètre essentiel, ce qui peut entraîner certaines restrictions sur le choix de l'emplacement du dispositif de raccordement.

D'autres détails et avantages de l'objet de l'invention ressortent du dessin d'exemples de réalisation d'un dispositif de raccordement d'un élément chauffant plat et de leur description détaillée qui suit.

Dans des représentations simplifiées et non à l'échelle:
la figure 1 représente une vue globale en perspective d'un élément chauffant plat avec un dispositif de raccordement selon l'invention;
la figure 2 représente une vue de la zone du raccordement avec une pièce de garniture insérée pour la fixation du dispositif de raccordement;
la figure 3 représente une vue en coupe d'un premier mode de réalisation du dispositif de raccordement, suivant la ligne III-III de la figure 1;
la figure 4 représente une vue en coupe, qui correspond à celle de la figure 3, d'un deuxième mode de réalisation du dispositif de raccordement selon l'invention ; et
la figure 5 représente une autre vue en coupe correspondant à la figure 3, d'une troisième forme de réalisation du dispositif de raccordement selon l'invention.

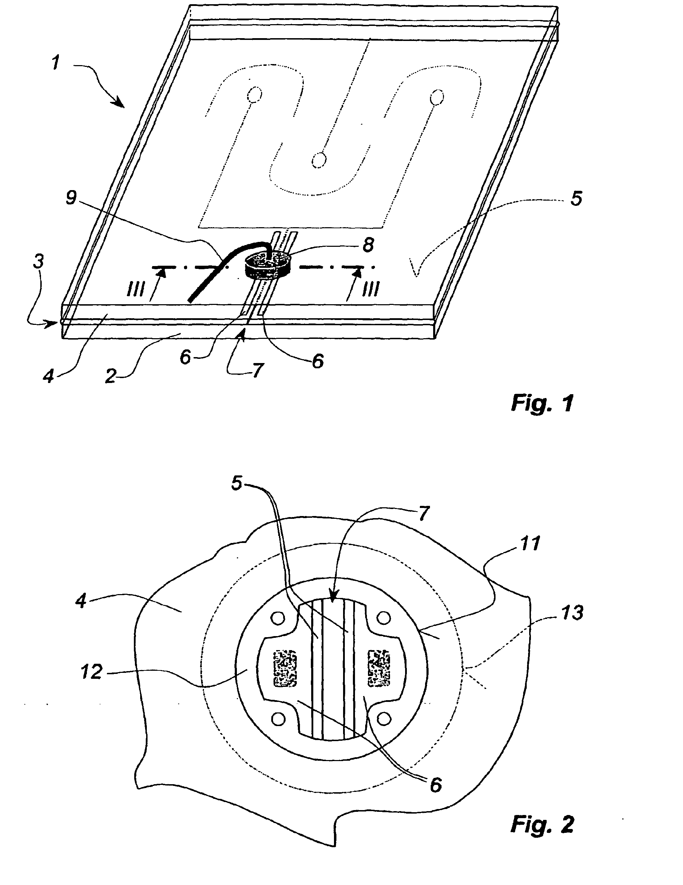

Selon la figure 1, un élément chauffant plat 1 est réalisé sous la forme d'un ensemble de vitrage doté d'une première vitre rigide 2, d'une couche intermédiaire 3 et d'une deuxième vitre rigide 4. La première vitre rigide 2 est de préférence un vitrage précontraint thermiquement qui est doté sur sa surface tournée vers la couche intermédiaire 3 d'une couche chauffante 5 configurée comme revêtement électriquement conducteur. La couche chauffante 5 est constituée d'une composition et/ou d'une succession de couches qui convient pour un fonctionnement comme couche chauffante plate et qui peut être sollicitée thermiquement suffisamment pour la précontrainte de la vitre. Des systèmes de couches appropriés ont été décrits de nombreuses fois dans l'état de la technique, de sorte qu'il ne faut pas rentrer davantage dans leurs détails. Ils peuvent être fabriqués avec une transmission élevée de la lumière visible et donc de manière à être transparents.

Des dispositions appropriées garantissent que ledit revêtement 5 soit passivé à la périphérie, le long du bord de l'élément chauffant plat 1, c'est-à-dire qu'il n'existe ni de contact électriquement conducteur vers sa surface extérieure ou frontale ni le risque d'une attaque corrosive par l'extérieur sur le matériau en couches. Par exemple, on peut prévoir dans le revêtement 5, à petite distance du bord extérieur de l'élément chauffant plat 1, une ligne de séparation périphérique continue qui remplit ces deux missions. En variante, on peut également, de manière connue, libérer complètement du matériau en couches ou enlever ultérieurement une étroite bande périphérique le long du bord de l'élément chauffant plat 1. En tout cas, on crée à l'aide du matériau synthétique adhésif thermoplastique qui forme la couche intermédiaire 3 (par exemple du polyvinylbutyral (PVB) ou du vinylacétate d'éthylène (VA)) une fermeture hermétique de l'interstice de bordure. On comprend que le matériau de la couche intermédiaire doit être sélectionné de manière à être bien compatible avec le matériau du revêtement 5.

Dans la figure 1, on peut voir les composants essentiels de l'alimentation électrique de la couche chauffante 5, à savoir d'abord deux électrodes planes 6 en forme de ruban qui sont disposées des deux côtés d'une ligne de séparation 7 qui isole l'un vis-à-vis de l'autre les deux pôles de la couche chauffante 5. Le déroulement du parcours de courant entre les deux électrodes est prédéterminé par les lignes structurelles ménagées dans la couche chauffante et ressort sans problème du dessin. Une boîte de raccordement 8 dotée d'un câble de raccordement 9 (qui n'est représenté qu'en partie) est fixée à l'endroit du contact électrique entre la couche chauffante 5 et la paire d'électrodes 6 sur la deuxième vitre rigide. De manière particulièrement avantageuse, l'ensemble des dispositifs et interfaces électriques sont rassemblés localement en un emplacement de l'élément chauffant plat 1.

A la différence de la représentation de la figure 1, les électrodes peuvent naturellement présenter d'autres formes que celles d'un ruban (par exemple un demi-cercle). En outre, on peut faire commencer des lignes structurelles dans la zone de la couche chauffante qui est recouverte par les électrodes, de sorte que l'électrode soit mise en contact électrique avec plusieurs parcours de courant raccordés électriquement en parallèle. Une telle configuration ou structuration de la couche chauffante à côté de sa zone de raccordement peut surtout être nécessaire lorsque l'alimentation en courant ne pourrait pas être possible à proximité du bord, à la différence de ce que l'on a représenté.

Dans la figure 2, on peut voir la zone des raccordements électriques de l'élément chauffant plat dans une vue en plan dans laquelle on a omis de représenter la boîte de raccordement. La vitre 4 qui peut également être réalisée en verre (éventuellement précontraint) ou en matière synthétique, présente un alésage 11 dans lequel une pièce de garniture 12 en forme de douille est insérée fixement. Son périmètre extérieur est adapté de la manière la plus exacte possible au diamètre ou au périmètre de l'alésage 11. Par une saillie en collet débordant 13, configurée ici comme épaulement annulaire, cette pièce de garniture 12 s'accroche derrière le bord de l'alésage 11 dans le plan de la couche intermédiaire 3. L'espace intérieur libre de la pièce de garniture 12 libère de manière visible la couche chauffante 5, les deux électrodes 6 et la ligne de séparation 7. Les surfaces sont représentées par des champs rectangulaires gris sur lesquels les contacts de raccordement électrique peuvent venir se placer.

La pièce de garniture 12 peut comprendre des éléments façonnés qui servent à fixer et à empêcher le dispositif de raccordement de tourner. Dans cet exemple de réalisation, ce sont des becs formés dans la paroi de son alésage et dotés d'alésages dans lesquelles des vis peuvent être vissées. A la différence de la représentation, ces éléments façonnés peuvent être disposés de manière non symétrique pour permettre l'insertion en position correcte d'autres composants.

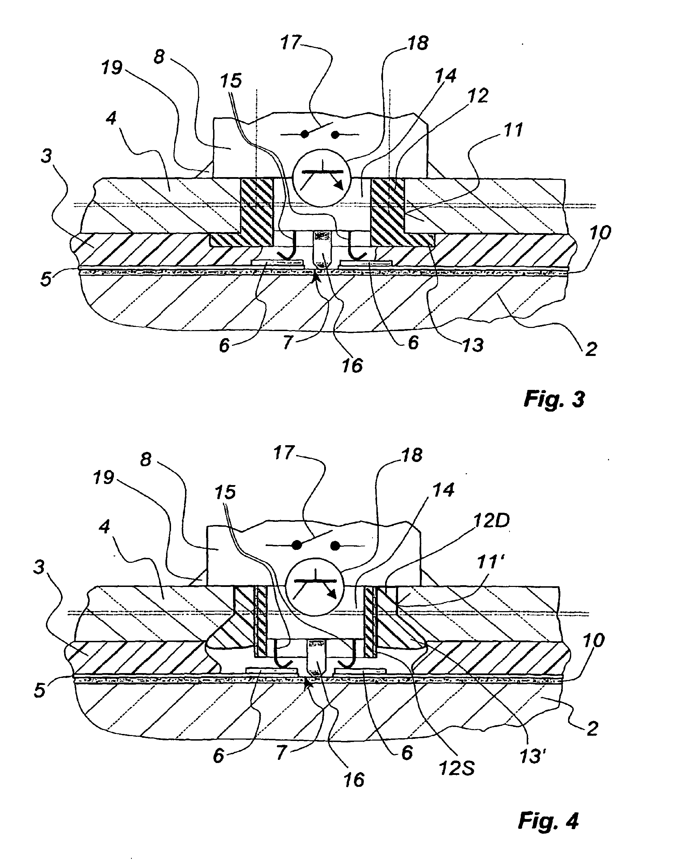

La figure 3 représente des détails plus poussés d'un exemple de structure du dispositif de raccordement électrique selon l'invention, en coupe, des pièces identiques étant dotées d'une autre référence numérique que dans les figures 1 et 2. On peut voir la structure en plusieurs couches de l'élément chauffant plat. On a représenté une partie de l'épaisseur de la vitre rigide 2, et une double ligne en chaînette qui traverse la vitre rigide 4 indique également que son épaisseur a été représentée raccourcie. Il est évident que ces deux vitres rigides peuvent être nettement plus épaisses que la couche intermédiaire 3. Dans la zone des électrodes 6 et de la boîte de raccordement 8 (qui n'est ici représentée que partiellement), leur matériau a été enlevé pour permettre un accès sans obstacle aux électrodes 6. Cet enlèvement de matière doit être dimensionné avant la liaison des deux vitres rigides par fusion de la couche intermédiaire 3 de telle sorte que le matériau adhésif ne puisse avancer jusqu'aux électrodes.

Dans la présente représentation, le diamètre de l'alésage 11 a été représenté plus petit par rapport à l'épaisseur de la vitre 4; on comprend que l'alésage est dimensionné à une largeur suffisante pour le type chaque fois prévu de dispositif de raccordement.

Un masquage optique de la zone de raccordement n'est pas nécessaire à son fonctionnement, et remplit uniquement une mission esthétique. A l'état monté, la vitre 2 et donc le côté de l'élément chauffant plat non tourné vers le dispositif de raccordement, formera son côté visible. Ce n'est qu'à titre d'exemple que l'on a prévu dans la zone du raccordement des électrodes 6 une couche opaque 10 entre la couche chauffante 5 et la surface de verre pour masquer cette zone vis-à-vis de l'extérieur. Si nécessaire, on peut évidemment aussi obtenir le même effet avec d'autres moyens, par exemple par teinture de la vitre rigide 2 dans la masse, application d'un décor sur sa surface extérieure et/ou conception de la couche chauffante elle-même comme miroir, par exemple en omettant une couche anti-réfléchissante sur son côté proche du substrat.

Par ailleurs, les électrodes proprement dites peuvent également être utilisées comme éléments décoratifs en leur donnant un aspect optiquement attrayant. On pourra alors se passer de la couche opaque 10.

Ainsi qu'on peut déjà le voir dans la figure 2, la pièce de garniture 12 en forme de douille est fixée dans l'alésage 11 de la deuxième vitre rigide 4. Sa longueur axiale correspond sensiblement à l'épaisseur de la vitre rigide 4 (quelques millimètres) et elle pénètre encore dans le plan de la couche intermédiaire 3. Sa saillie 13 qui déborde en collet radial vers l'extérieur s'engage derrière le bord de l'alésage 11, de sorte que la pièce de garniture 12 y est maintenue en correspondance de forme et ne peut en être extraite.

Ainsi qu'on l'a fait remarquer plus haut, cette pièce de garniture doit être insérée dans l'alésage 11 avant la liaison des deux vitres rigides 2 et 4. Ce n'est qu'après fusion de la couche intermédiaire thermoplastique 3 qu'elle est fixée définitivement. Dans le dessin, on peut voir que la saillie 13 est encore superposée au matériau de la couche intermédiaire.

La pièce de garniture 12 forme la base de la boîte de raccordement 8. Deux lignes verticales en chaînette désignent une liaison vissée entre les deux parties. Un bloc de support 14 est fixé par la boîte de raccordement 8 dans l'alésage de la pièce de garniture 12, d'où partent deux contacts à ressort 15 qui s'étendent jusqu'aux électrodes 6 et qui reposent de manière électriquement conductrice sur celles-ci. Une sonde de température 16 indiquée symboliquement est également maintenue à l'aide du bloc de contact 14 et de la pièce de garniture 12 en contact avec la surface revêtue de la vitre rigide 2. Elle sert à détecter la température effective dans la zone de contact des électrodes 6. Le bloc de support 14 est inséré en position correcte, éventuellement forcé par des éléments façonnés appropriés, dans la pièce de garniture 12 de sorte que les contacts à ressort 15 entrent en contact avec l'électrode chaque fois prévue, et ensuite immobilisé. Le bloc de support peut former une première unité fixe avec la boîte de raccordement 8 et être fixé en même temps que cette dernière dans la pièce de garniture 12.

Bien que dans l'utilisation prévue sur un élément chauffant plat 1, les contacts à ressort 15 satisfassent les exigences d'une liaison électrique sûre et durable, en cas de besoin, ils pourraient être soudés, en particulier grâce à un pré-étamage approprié, la chaleur nécessaire pouvant être apportée sans contact, par exemple à travers la vitre revêtue 2.

Les symboles de commutation d'un commutateur 17 et d'un transistor 18 représentent l'équipement électrique ou électronique du bloc de support 14 ou de la boîte de raccordement 8 et peuvent chaque fois représenter une pluralité d'éléments correspondants. D'autres missions de commande et de commutation sont également attribuées à cette zone du dispositif de raccordement en plus de l'apport de la tension électrique d'alimentation aux électrodes 6 par les câbles de raccordement 9.

Un élément de commutation doit évaluer les valeurs mesurées par la sonde de température 16 et éventuellement débrancher au moins temporairement l'apport de courant à la couche chauffante si la température effective devait dépasser un seuil admissible. Cependant, on peut également prévoir un élément de commutation qui assure la protection contre des dépassements de température et qui limite de manière connue en soi la puissance électrique consommée à des valeurs admissibles.

Au moins un commutateur qui peut présenter une configuration électronique ou électromécanique gère l'apport de courant à la couche chauffante. Ce commutateur peut être fondamentalement branché manuellement et localement et être commandé par des capteurs, par exemple la sonde de température 16, ou par un dispositif de commande à distance. Ainsi qu'on l'a déjà indiqué, ce dernier peut former une partie d'une régulation automatique de la température d'un local (installation de climatisation, etc.) mais peut également être facultativement et fondamentalement commandée à la main.

Si les signaux de commande sont transmis sans fil, un récepteur approprié ainsi qu'un décodeur et d'autres moyens de commutation (par exemple des amplificateurs) devront être prévus dans la boîte de raccordement 8 ou dans le bloc de support 14. Si les signaux de commande sont transmis par des conducteurs, il faudra prévoir des organes d'évaluation appropriés dans ce but, en particulier au cas où des signaux de commande sont transmis par les conducteurs de raccordement au réseau, de toute façon présents (câble 9), et doivent être filtrés sur place.

On n'a pas représenté ici des éléments d'affichage de l'état de fonctionnement de l'élément chauffant plat 1. Dans une variante préférée, ces derniers peuvent être configurés en forme de signaux lumineux (diodes luminescentes) et par exemple être disposés dans la zone de la ligne de séparation 7 entre les contacts à ressort 15 et à côté de la sonde de température 16 de manière à pouvoir être visibles par le côté extérieur de la vitre rigide 2. Ils sont également alimentés électriquement par l'intermédiaire du bloc de support 14 et commandés par lesdits éléments de commutation 17, 18.

Après la fabrication et la vérification du fonctionnement du dispositif de raccordement, si nécessaire, on peut encore rendre la transition entre la surface de la vitre et la boîte de raccordement 8 étanche par un joint d'étanchéité 19. A la différence de ce que l'on a représenté, on peut évidemment aussi disposer ce joint d'étanchéité directement entre le côté inférieur de la boîte de raccordement 8 et la surface de la vitre.

La figure 4 représente, dans une vue en coupe qui correspond à celle de la figure 3, une variante d'une pièce de garniture qui est ici utilisée dans un alésage en contre-dépouille 11' de la deuxième vitre rigide 4. Si l'on y a représenté les mêmes composants que dans la figure 2, ces derniers reçoivent les mêmes références numériques et ne sont plus expliqués. La pièce de garniture est réalisée en deux pièces, avec une cheville à contre-dépouille 12D et une vis à douille 12S. On connaît déjà de telles douilles à contre-dépouille dans de nombreuses applications sur du verre. La réalisation d'alésages 11' en contre-dépouille ou en creux dans des vitres de verre est également techniquement mûre.

La cheville 12D à contre-dépouille peut être insérée par l'extérieur dans l'alésage 11' après la réalisation de l'ensemble. On visse alors la vis à douille 12S qui peut être réalisée en métal ou en une matière synthétique à haute résistance. Des lignes verticales le long de son port extérieur indiquent son filet extérieur autotaraudeur. Lors du vissage s'établit la déformation indiquée de la cheville à contre-dépouille 12D en une saillie 13' qui déborde radialement en collet. On voit que cette saillie remplit le chanfrein à contre-dépouille de l'alésage 11' en correspondance géométrique jusqu'à ce que son extraction axiale devienne impossible. De même, la vis à douille 12S est immobilisée radialement et axialement dans l'alésage par engagement de son filet extérieur dans la cheville.

La pénétration éventuelle de la cheville à contre-dépouille 12D dans le plan de la couche intermédiaire ne peut pas conduire à des contraintes locales excessives qui pourraient avoir pour effet une délamination locale ou même la rupture d'une vitre. En cas de doute, on enlèvera le matériau de la couche intermédiaire au cas où il n'est pas assez déformable dans la zone de l'alésage 11' sur la distance indiquée, et donc sensiblement jusqu'à son bord, de telle sorte que la cheville puisse se dilater librement dans le plan de la couche intermédiaire.

La vis à douille proprement dite ne peut également être vissée que jusqu'à une profondeur prédéterminée pour ne pas entrer en contact avec les électrodes dans le fond de l'alésage 11' ou endommager ces dernières ou la couche chauffante 5. Elle ne peut pas davantage venir toucher les ressorts de contact 15.

Au contraire d'une fixation de verre portante, dans la présente application, il ne faut pas s'attendre à ce que des forces élevées agissent, de sorte que la force de serrage de la cheville ne doit pas être particulièrement élevée. Cependant, il peut être nécessaire de réaliser également la vitre 4 en verre précontraint, et dans ce cas l'alésage 11' devra être ménagé avant la précontrainte.

Dans une variante particulièrement avantageuse, la boîte de raccordement 8 et la vis à douille 12S peuvent être rassemblées en une entité fixe. On pourrait alors utiliser le boîtier de la boîte de raccordement comme levier pour visser la vis à douille à la main, le côté inférieur de la boîte de raccordement qui vient se placer sur le côté supérieur de la vitre 4 au bord de l'alésage 11' formant alors une butée de profondeur.

Dans cette unité, le bloc de support peut être fixé en position correcte avec les ressorts de contact et éventuellement la sonde de température.

Alors que dans les deux figures 3 et 4, la pièce de garniture se raccorde pratiquement à chant avec la surface principale de la vitre rigide 4, la boîte de raccordement déborde légèrement au-dessus de cette surface. Comme ce côté de l'élément chauffant plat 1 n'est la plupart du temps pas tourné vers l'observateur/l'utilisateur à l'état monté, est éventuellement situé face à une paroi ou est intégré dans cette dernière, la visibilité du dispositif de raccordement sur le masque (ou éventuellement sur les électrodes opaques configurées comme éléments de décoration) reste d'une part limitée, et d'autre part des risques par manipulation non autorisée ou par inadvertance du dispositif de raccordement sont exclus dans la pratique. S'il est prévu une poignée pour l'actionnement d'un organe de commande du dispositif de raccordement, on disposera ce dernier naturellement de préférence en des endroits bien accessibles, par exemple à proximité du bord de l'élément chauffant plat.

Bien qu'à propos de la figure 4, on n'ait parlé que d'une cheville à contre-dépouille pour l'application "alésage à contre-dépouille" dans la deuxième vitre rigide 4, en cas de besoin, en particulier si l'épaisseur de la vitre 4 est assez limitée, par exemple inférieure à 5 mm, on peut utiliser dans ce but comme pièce de garniture d'autres composants appropriés, du type déjà indiqué et similaires à celui de la pièce de garniture 12 de la figure 2.

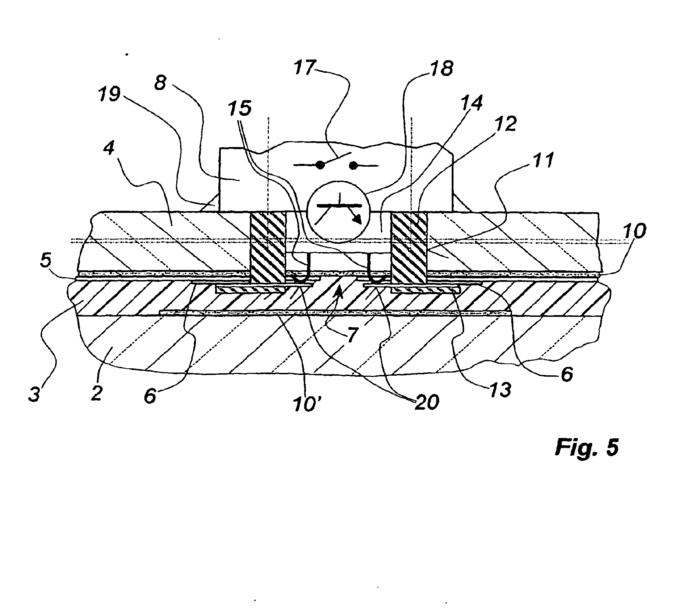

La réalisation selon la figure 5 combine un dispositif de raccordement selon l'invention avec un élément en plaque, dans lequel les éléments fonctionnels électriques à raccorder se trouvent sur la deuxième vitre rigide 4 pourvue de l'alésage 11. Contrairement aux variantes décrites ci-dessus, il n'est ici prévu aucun contact direct entre les contacts à ressort 15 et les électrodes planes 6 de la couche chauffante 5. La saillie 13 de la pièce de garniture 12 sert au contraire à maintenir en contact les ponts de raccordement 20 avec les électrodes planes 6, après que la pièce de garniture 12 a été insérée et fixée dans l'alésage 11 de la vitre rigide 4. Comme la pièce de garniture peut être serrée avec la boîte de raccordement 8 et donc que la saillie 13 est tirée avec une précontrainte contre les électrodes planes 6, ce point de contact n'est pas particulièrement critique. Les surfaces des ponts de raccordement venant en contact avec les électrodes planes peuvent être rendues rugueuse ou pourvues de pointes afin de permettre une légère pénétration des ponts de raccordement dans les électrodes planes. On peut ici aussi toutefois, comme déjà mentionné ci-dessus, réaliser un soudage par apport de chaleur, avec un pré-étamage des ponts de raccordement et/ou des électrodes planes.

Les extrémités des ponts de raccordement 20 opposées aux électrodes planes 6 pénètrent dans l'espace interne de la pièce de garniture 12. Elles forment à cet endroit, de manière équivalente aux électrodes planes des applications précédentes, des faces d'appui pour les contacts à ressort 15 de sorte qu'après le montage, celles-ci soient raccordées électriquement de manière sûre par le biais d'un pont de raccordement respectif 20 aux électrodes planes 6 respectives proprement dites.

Les ponts de raccordement 20 sont de préférence intégrés fixement dans la pièce de garniture 12, afin de configurer aussi simplement que possible le montage du dispositif de raccordement. Ceci peut par exemple être obtenu par surmoulage des ponts de raccordement 20 (minces rubans de tôle) avec le matériau en plastique de la pièce de garniture 12 lors de sa mise en forme.

On reconnaît à nouveau la ligne de séparation 7 entre les deux pôles de la couche chauffante 5 et la couche opaque 10, sur laquelle la couche chauffante est déposée dans chaque cas dans la région de contact. En complément, on prévoit ici encore une autre couche opaque 10 sur le côté plan de la vitre rigide 2 se trouvant à l'intérieur dans le composite, qui couvre optiquement la région de contact et qui peut être réalisée en outre sous forme d'élément décoratif. Au choix, on peut, en fonction des besoins, omettre également une ou les deux couches opaques, car elles ne sont pas significatives pour le fonctionnement du dispositif de raccordement ou de l'élément en plaque.

Tandis que la couche intermédiaire adhésive 3 est continue dans la région de contact dans cette illustration, elle peut au besoin aussi également être pourvue dans cette variante d'une découpe de manière analogue aux figures 3 et 4.

Dans la figure 5, aucune sonde de température n'a certes été illustrée, mais l'on comprendra qu'un élément de détection approprié pour la détection de la température effective dans la région de raccordement peut également être prévu dans cette variante de réalisation. Il serait envisageable par exemple de réaliser une sonde thermique supplémentaire de manière similaire aux ponts de raccordement 20 illustrés ici et de la mettre en contact avec la couche chauffante ou une électrode plane.

Lorsque ce dispositif de raccordement est utilisé pour des éléments fonctionnels électriques d'autres types, par exemple pour des cellules solaires en couches minces ou des sondes d'impact ou de précipitation, ainsi qu'on l'a indiqué au début, sa structure fondamentale n'est pas modifiée par rapport à celle des exemples de réalisation représentés ici. En s'écartant des dessins, on peut éventuellement prévoir uniquement un seul contact ou une pluralité de contacts dans chaque découpe.

## Revendications

1. Elément plat (1) chauffant en plusieurs couches et son dispositif de raccordement, l'élément plat comprenant une première vitre rigide (2) dotée d'un revêtement électriquement conducteur (5) ainsi qu'une deuxième vitre rigide (4) reliée à plat au côté de la première vitre rigide, cette deuxième vitre présentant au moins une découpe (11; 11') pour la réalisation d'un raccordement électrique ou revêtement électriquement conducteurs et le dispositif de raccordement comprenant de garniture (12; 12D, 12S) qui est fixée dans ladite découpe (11; 11') par une saillie (13, 13') dont le bord est situé dans le plan entre les deux vitres rigides (2, 4) et/ou accroche par l'arrière une contre-dépouille de la découpe, la pièce de garniture (12; 12D, 12S) servant de contre-appui pour la fixation d'au moins une pièce de raccordement (15) reliée électriquement au revêtement électriquement conducteur (5), **caractérisé en ce que** l'élément plat est transparent, le revêtement électriquement conducteur est constitué d'une couche chauffante transparente et est passivé à la périphérie de l'élément plat, cette couche chauffante présentant pour son alimentation électrique deux zones de polarité différente qui sont amenées dans la zone de découpe (11,11') et constituées de deux électrodes planes (6) en forme de ruban disposées des deux côtés d'une ligne de séparation (7) isolant les deux zones l'une de l'autre, et **en ce que** chacune de ces zones est mise en contact électrique avec une pièce de raccordement (15) fixée sur la pièce de garniture.

2. Elément plat et son dispositif de raccordement selon la revendication 1, **caractérisé en ce que** la découpe (11) est prévue dans la vitre rigide pourvue de la couche chauffante ou dans l'autre vitre rigide.

3. Elément plat et son dispositif de raccordement selon la revendication 1 ou 2 ou 3, **caractérisé en ce que** chaque pièce de raccordement comprend au moins un contact à ressort (15) mis en contact électrique avec la couche chauffante.

4. Elément plat et son dispositif de raccordement selon l'une des revendications précédentes, **caractérisé en ce que** la pièce de garniture (12) est configurée en forme de douille et est insérée dans la découpe (11), sa saillie (13) ;accrochant par l'arrière le bord de la découpe dans le plan de la couche intermédiaire (3).

5. Elément plat et son dispositif de raccordement selon la revendication 1 **caractérisé en ce que** la saillie (13) de la pièce de garniture (12) est pourvue d'au moins un moyen de contact (20), qui est prévu pour la réalisation d'une connexion électrique entre au moins une pièce de raccordement (15) et la couche chauffante.

6. Elément plat et son dispositif de raccordement selon la revendication 5 **caractérisé en ce qu'**un moyen de contact est réalisé en tant que pont de raccordement (20) qui présente, dans l'espace interne de la pièce de garniture (12) en forme de douille, une surface de contact pour une pièce de raccordement (15) et sur une face de la saillie (13), une surface de contact pour la connexion à la couche chauffante.

7. Elément plat et son dispositif de raccordement selon l'une des revendications précédentes, **caractérisé en ce que** la pièce de garniture comprend une cheville, en particulier une cheville à contre-dépouille (12D) qui est fixée dans la découpe (11') au moyen d'une vis (12S) .

8. Elément plat et son dispositif de raccordement selon la revendication 9, **caractérisé en ce que** la vis est configurée comme vis à douille (12S) avec filet extérieur, son espace intérieur formant un logement pour d'autres composants du dispositif de raccordement.

9. Elément plat et son dispositif de raccordement selon l'une des revendications précédentes, **caractérisé en ce qu'**il est doté de moyens pour la fixation ou la suspension de l'élément plat dans une structure sous-jacente, en particulier dans la paroi d'un bâtiment.

10. Elément plat et son dispositif de raccordement selon la revendication 7 **caractérisé par** au moins une sonde de température (16) pour la détection de la température effective de la couche chauffante (5).

11. Elément plat et son dispositif de raccordement selon la revendication 10 **caractérisé par** un élément de commutation (17, 18) apte à être commandé par la sonde de température (16), pour interrompre ou réduire le courant du chauffage en cas de dépassement d'un seuil de température prédéterminé.

12. Elément plat et son dispositif de raccordement selon l'une des revendications précédentes, **caractérisé par** un dispositif de réglage actionné à la main pour l'introduction d'un seuil de température de la couche chauffante.

13. Elément plat et son dispositif de raccordement selon l'une des revendications précédentes, **caractérisé par** un récepteur de signaux de commande transmis sans contact et par un dispositif de commutation (17, 18) apte à être commandé par le récepteur, pour le branchement et le débranchement commandé à distance de la couche chauffante.

14. Elément plat et son dispositif de raccordement selon l'une des revendications précédentes, **caractérisé par** au moins un élément d'affichage, en particulier un signal lumineux, de l'état de fonctionnement de la couche chauffante.

15. Elément plat et son dispositif de raccordement selon l'une des revendications précédentes, **caractérisé par** une boîte de raccordement (8) en forme de boîtier pour assurer la couverture vis-à-vis de l'extérieur.

16. Elément plat et son dispositif de raccordement selon l'une des revendications précédentes, dont une plaque rigide est un vitrage (2).

17. Elément plat et son dispositif de raccordement selon l'une des revendications précédentes, **caractérisé en ce qu'**au moins dans la zone de la découpe ou du dispositif de raccordement, un masque optique est prévu sur le côté non tourné vers la découpe.

## Patentansprüche

1. Mehrschichtiges Flächenheizelement (1) und seine Anschlussvorrichtung, wobei das Flächenelement eine mit einer elektrisch leitfähigen Beschichtung (5) versehene erste starre Scheibe (2) sowie eine mit der ersten starren Scheibe flächig verbundene zweite starre Scheibe (4) umfasst, wobei diese zweite Scheibe mindestens eine Ausnehmung (11; 11') zum Herstellen eines elektrischen Anschlusses zu den elektrisch leitfähigen Beschichtung (5) aufweist, und die Anschlussvorrichtung ein Einsatzteil (12; 12D, 12S) umfasst, das in besagter Ausnehmung (11; 11') mit einem deren Rand in der zwischen den beiden starren Scheiben (2, 4) liegenden Ebene und/ oder einen Hinterschnitt der Ausnehmung hintergreifenden Vorsprung (13; 13') festgelegt ist, wobei das Einsatzteil (12; 12D, 12S) als Widerlager zum Befestigen wenigstens eines elektrisch mit elektrisch leitfähigen Beschichtung (5) verbundenen Anschlussteils (15) dient, **dadurch gekennzeichnet, dass** das Flächenelement transparent ist, die elektrisch leitende Beschichtung aus einer transparenten Heizschicht besteht und am Umfang des Flächenelements passiviert ist, wobei diese Heizschicht als elektrische Zuleitung zwei Bereiche mit unterschiedlicher Polarität auf, die in den Bereich der Ausnehmung (11; 11') eingeführt werden und aus zwei flachen, streifenförmigen Elektroden (6) bestehen, die auf beiden Seiten einer die beiden Bereiche voneinander isolierenden Trennungslinie (7) angeordnet sind, und **dadurch**, dass jeder dieser Bereiche mit einem am Einsatzteil befestigten Anschlusselement (15) elektrisch verbunden ist.

2. Flächenelement und seine Anschlussvorrichtung nach Anspruch 1, **dadurch gekennzeichnet, dass** die Ausnehmung (11) in der mit der Heizschicht versehenen starren Scheibe oder in der anderen starren Scheibe vorgesehen ist.

3. Flächenelement und seine Anschlussvorrichtung nach Anspruch 1 oder 2, **dadurch gekennzeichnet, dass** jedes Anschlussteil mindestens einen mit der Heizschicht elektrisch kontaktierten Federkontakt (15) umfasst.

4. Flächenelement und seine Anschlussvorrichtung nach einem der vorstehenden Ansprüche, **dadurch gekennzeichnet, dass** das Einsatzteil (12) hülsenförmig ausgebildet und in die Ausnehmung (11) eingesetzt ist, wobei sein Vorsprung (13) den Rand der Ausnehmung in der Ebene der Zwischenschicht (3) hintergreift.

5. Flächenelement und seine Anschlussvorrichtung nach Anspruch 1, **dadurch gekennzeichnet, dass** der Vorsprung (13) des Einsatzteils (12) mit mindestens einem Kontaktmittel (20) versehen ist, das zum Herstellen einer elektrischen Verbindung zwischen mindestens einem Anschlussteil (15) und der Heizschicht vorgesehen ist.

6. Flächenelement und seine Anschlussvorrichtung nach Anspruch 5, **dadurch gekennzeichnet, dass** ein Kontaktmittel als Anschlussbrücke (20) ausgeführt ist, welche im Innenraum des hülsenförmigen Einsatzteils (12) eine Kontaktfläche für ein Anschlussteil (15) und auf einer Fläche des Vorsprungs (13) eine Kontaktfläche zum Verbinden mit der Heizschicht aufweist.

7. Flächenelement und seine Anschlussvorrichtung nach einem der vorstehenden Ansprüche, **dadurch gekennzeichnet, dass** das Einsatzteil einen Dübel, insbesondere einen Hinterschnittdübel (12D) umfasst, der mithilfe einer Schraube (12S) in der Ausnehmung (11') festgelegt ist.

8. Flächenelement und seine Anschlussvorrichtung nach Anspruch 7, **dadurch gekennzeichnet, dass** die Schraube als Hülsenschraube (12S) mit Außengewinde ausgeführt ist, deren Innenraum eine Aufnahme für weitere Bauteile der Anschlussvorrichtung bildet.

9. Flächenelement und seine Anschlussvorrichtung nach einem der vorstehenden Ansprüche, **dadurch gekennzeichnet, dass** sie mit Mitteln zum Befestigen oder Aufhängen des Flächenelements an einer Unterkonstruktion, insbesondere an einer Gebäudewand, versehen ist.

10. Flächenelement und seine Anschlussvorrichtung nach Anspruch 7, **gekennzeichnet durch** mindestens einen Temperaturfühler (16) zum Erfassen der Ist-Temperatur der Heizschicht (5).

11. Flächenelement und seine Anschlussvorrichtung nach Anspruch 10, **gekennzeichnet durch** ein vom Temperaturfühler (16) steuerbares Schaltelement (17, 18) zum Unterbrechen oder Reduzieren des Heizstroms bei Überschreiten einer vorgegebenen Temperaturschwelle.

12. Flächenelement und seine Anschlussvorrichtung nach einem der vorstehenden Ansprüche, **gekennzeichnet durch** einen manuell betätigbaren Einsteller zum Vorgeben einer Temperaturschwelle der Heizschicht.

13. Flächenelement und seine Anschlussvorrichtung nach einem der vorstehenden Ansprüche, **gekennzeichnet durch** einen Empfänger für kontaktlos übertragbare Steuersignale und **durch** eine von dem Empfänger steuerbare Schalteinrichtung (17, 18) zum fernsteuerbaren Ein- und Ausschalten der Heizschicht.

14. Flächenelement und seine Anschlussvorrichtung nach einem der vorstehenden Ansprüche, **gekennzeichnet durch** mindestens ein Anzeigeelement, insbesondere ein Lichtsignal, für den Betriebszustand der Heizschicht.

15. Flächenelement und seine Anschlussvorrichtung nach einem der vorstehenden Ansprüche, **gekennzeichnet durch** eine Anschlussdose (8) in Gehäuseform als Abdeckung nach außen.

16. Flächenelement und seine Anschlussvorrichtung nach einem der vorstehenden Ansprüche, **dadurch gekennzeichnet, dass** dessen eine starre Platte eine Glasscheibe (2) ist.

17. Flächenelement und seine Anschlussvorrichtung nach einem der vorstehenden Ansprüche, **dadurch gekennzeichnet, dass** mindestens im Bereich der Ausnehmung oder der Anschlussvorrichtung auf der von der Ausnehmung abgewandten Seite eine optische Kaschierung vorgesehen ist.

## Claims

1. Flat multilayer heating element (1) and its connector, the flat element comprising a first rigid glazing pane (2) provided with an electrically conductive coating (5) and a second rigid glazing pane (4) joined flat to the side of the first rigid glazing pane, this second pane having at least one cutout (11; 11') for making an electrical connection to the electrically conductive coating, and the connector comprising a liner (12; 12D, 12S) which is fastened in said cutout (11; 11') by a projection (13, 13'), the edge of which lies in the plane between the two rigid panes (2, 4) and/or catches, via the rear, on an undercut of the cutout, the liner (12; 12D, 12S) serving as a counterbearing surface for fastening at least one connection piece (15) electrically connected to the electrically conductive coating (5), **characterized in that** the flat element is transparent and the electrically conductive coating consists of a transparent heating layer and is passivated on the periphery of the flat element, this heating layer having, for its electrical supply, two regions of different polarity that are brought into the region of the cutout (11, 11') and consist of two plane electrodes (6) in the form of a ribbon, which are placed on both sides of a line of separation (7) that isolates the two regions from each other, and **in that** each of these regions is brought into electrical contact with a connection piece (15) fastened to the liner.

2. Flat element and its connector according to Claim 1, **characterized in that** the cutout (11) is provided in the rigid pane having the heating layer or in the other rigid pane.

3. Flat element and its connector according to Claim 1 or 2 or 3, **characterized in that** each connection piece comprises at least one spring contact (15) brought into electrical contact with the heating layer.

4. Flat element and its connector according to one of the preceding claims, **characterized in that** the liner (12) is configured in the form of a bush and is inserted into the cutout (11), its projection (13) catching, via the rear, on the edge of the cutout in the plane of the interlayer (3).

5. Flat element and its connector according to Claim 1, **characterized in that** the projection (13) of the liner (12) is provided with at least one contact means (20), which is designed for making an electrical connection between at least one connection piece (15) and the heating layer.

6. Flat element and its connector according to Claim 5, **characterized in that** a contact means is produced as a connection bridge (20) which has, in the internal space of the liner (12) in the form of a bush, a contact surface for a connection piece (15) and, on one face of the projection (13), a contact surface for connection to the heating layer.

7. Flat element and its connector according to one of the preceding claims, **characterized in that** the liner comprises a peg, in particular an undercut-engaging peg (12D) that is fastened in the cutout (11') by means of a screw (12S).

8. Flat element and its connector according to Claim 9, **characterized in that** the screw is configured as a bush screw (12S) with an external thread, its internal space forming a housing for other components of the connector.

9. Flat element and its connector according to one of the preceding claims, **characterized in that** it is provided with means for fastening or suspending the flat element in a subjacent structure, in particular in the wall of a building.

10. Flat element and its connector according to Claim 7, **characterized by** at least one temperature probe (16) for detecting the actual temperature of the heating layer (5).

11. Flat element and its connector according to Claim 10, **characterized by** a switching element (17, 18) that can be controlled by the temperature probe (16), in order to interrupt or reduce the heating current should a predetermined temperature threshold be exceeded.

12. Flat element and its connector according to one of the preceding claims, **characterized by** a manually actuated adjustment device for introducing a temperature threshold for the heating layer.

13. Flat element and its connector according to one of the preceding claims, **characterized by** a receiver for receiving control signals transmitted without any contact and by a switching device (17, 18) that can be controlled by the receiver, for remotely connecting and disconnecting the heating layer.

14. Flat element and its connector according to one of the preceding claims, **characterized by** at least one display element, in particular a light signal, for displaying the state of operation of the heating layer.

15. Flat element and its connector according to one of the preceding claims, **characterized by** a connection box (8) in the form of a casing acting as a cover with respect to the external environment.

16. Flat element and its connector according to one of the preceding claims, one rigid plate of which is a pane (2).

17. Flat element and its connector according to one of the preceding claims, **characterized in that** an optical mask is provided at least in the region of the cutout or of the connector on that side not facing the cutout.
